Europäisches Patentamt

European Patent Office

Office européen des brevets

(11) Veröffentlichungsnummer : **0 117 456**
**B1**

(12) **EUROPÄISCHE PATENTSCHRIFT**

(45) Veröffentlichungstag der Patentschrift :
**17.08.88**

(51) Int. Cl.⁴ : **H 01 L 25/08, H 02 M 7/10**

(21) Anmeldenummer : **84101067.1**

(22) Anmeldetag : **02.02.84**

(54) **Hochspannungskaskade.**

(30) Priorität : **02.02.83 DE 3303464**

(43) Veröffentlichungstag der Anmeldung :
**05.09.84 Patentblatt 84/36**

(45) Bekanntmachung des Hinweises auf die Patenterteilung : **17.08.88 Patentblatt 88/33**

(84) Benannte Vertragsstaaten :
**AT DE FR GB IT NL**

(56) Entgegenhaltungen :
**DE-A- 2 307 227**
**DE-A- 2 336 082**
**DE-A- 2 364 920**

(73) Patentinhaber : **Roederstein Spezialfabriken für Bauelemente der Elektronik und Kondensatoren der Starkstromtechnik GmbH**
**Ludmillastrasse 23/25**
**D-8300 Landshut (DE)**

(72) Erfinder : **Laxy, Helmut**
**Reitbergerstrasse 17**
**D-8391 Büchlberg (DE)**
Erfinder : **Rybarczik, Dieter**
**Lusenstrasse 8**
**D-8391 Ruderting (DE)**
Erfinder : **Utrata, Eberhard**
**Bayerwaldring 40**
**D-8391 Tittling (DE)**
Erfinder : **Schott, Lothar**
**Roedersteinstrasse 17**
**D-8359 Oberpolling (DE)**

(74) Vertreter : **Weickmann, Heinrich, Dipl.-Ing. et al**
**Patentanwälte Dipl.-Ing. H.Weickmann Dipl.-Phys.Dr. K.Fincke Dipl.-Ing. F.A.Weickmann Dipl.-Chem. B. Huber Dr.-Ing. H. Liska Dipl.-Phys.Dr. J. Prechtel**
**Postfach 860820**
**D-8000 München 86 (DE)**

EP 0 117 456 B1

Jouve, 18, rue St-Denis, 75001 Paris, France

## Beschreibung

Die Erfindung betrifft eine Hochspannungskaskade, insbesondere für Fernsehgeräte, umfassend innerhalb eines vergossenen Kaskadenkörpers eine erste und eine zweite jeweils wenigstens einen Teil der Pumpsäule bzw. der Speichersäule einer Kaskadenschaltung bildende Reihe jeweils aus länglichen, im wesentlichen gleich orientierten, in Richtung der jeweiligen Kondensatorlängsachsen hintereinander angeordneten, elektrisch unmittelbar miteinander verbundenen Kondensatoren und ferner umfassend mehrere zwischen die Kondensatoren der beiden parallel nebeneinander angeordneten Reihen geschaltete Dioden der Kaskadenschaltung, sowie einen mit dem Hochspannungsende der Speichersäule verbundenen Bleederwiderstand, wobei an das Niederspannungsende der Pumpsäule eine Pumpspannungs-Anschlußleitung, an das Hochspannungsende der Speichersäule eine Hochspannungs-Anschlußleitung und an den Bleederwiderstand eine Bleederwiderstands-Anschlußleitung angeschlossen sind, und wobei der Kaskadenkörper mit einem ausgegossenen Bechergehäuse gebildet ist, welches im Bereich der Niederspannungsenden der beiden Säulen mit einer zu den Reihenlängsrichtungen im wesentlichen senkrechten Anschlußplatte ausgebildet ist, die über den Querschnitt des Kaskadenkörpers wenigstens an einer Seite hervorkragt und wobei ferner unter Spannungen im kV-Bereich liegende Anschlußleitungen aus dem Kaskadenkörper im Bereich von dessen der Anschlußplatte gegenüberliegendem Ende herausgeführt sind.

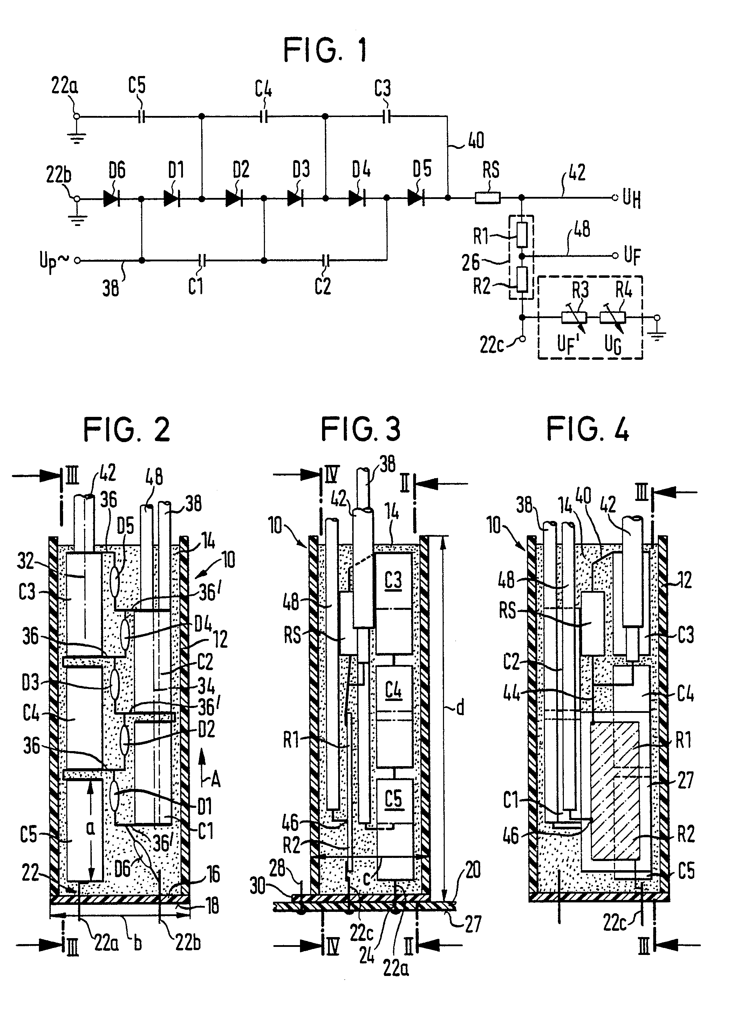

Eine Hochspannungskaskade dieser Art ist aus der DE-A-2 307 227 bekannt. Das Gehäuse ist hierbei mit einer Anschlußplatte versehen mit Montageschlitzen zur mechanischen Befestigung des Kaskadenkörpers an einem Träger. Die Anordnung der Kondensatoren in zur Anschlußplatte senkrechten Reihen gewährleistet kompakten Aufbau bei relativ kleiner Montagefläche. Die Herausführung von unter Spannungen im kV-Bereich liegenden Anschlußleitungen, beispielsweise der Hochspannungs-Anschlußleitung, mit entsprechend hoher Spannung (z. B. + 24 kV) aus dem Kaskadenkörper im Bereich von dessen der Anschlußplatte gegenüberliegendem Ende, vermeidet Fehlerspannungsinduzierung bzw. Spannungsüberschläge zum Träger. Sämtliche Anschlußleitungen sind durch die Seitenwandung des Bechergehäuses hindurchgeführt (Fig. 2). Die Möglichkeit für eine unmittelbare Platinenbestückung mit Platinenkontakt für Niederspannungsanschlüsse, insbesondere Masseanschlüsse, der Schaltung ist nicht gegeben. Der in der Fig. 3 angedeutete Spannungsregler ist mit der Hochspannungskaskade nicht baulich integriert, so daß eine gesonderte Verdrahtung und Platinenmontage des Spannungsreglers erforderlich ist.

Die Aufgabe der Erfindung liegt darin, eine Hochspannungskaskade der eingangs genannten Art mit kompaktem Aufbau bereitzustellen, welche, integriert mit einem Spannungsreglerteil, die unmittelbare Platinenbestückung bei vereinfachter Herstellbarkeit ermöglicht.

Diese Aufgabe wird dadurch gelöst, daß die Pumpspannungs-, die Hochspannungs- und die Bleederwiderstands-Anschlußleitung aus der Becheröffnung herausgeführt sind, daß der hervorkragende Plattenrand der mit einer Platinen-Anschlußfläche ausgebildeten Anschlußplatte mit wenigstens einem Anschlußstift zur Kontaktierung mit einer Platine versehen ist, und daß am Kaskadenkörper ein ein- oder mehrstufiges Spannungsreglerteil angebracht ist, das masseseitig mit wenigstens einem der Anschlußstifte verbunden ist und das über die Bleederwiderstands-Anschlußleitung an den Bleederwiderstand angeschlossen ist.

Da die genannten Anschlußleitungen aus der Becheröffnung herausgeführt sind, erübrigen sich entsprechende Leitungsdurchführungen durch die Becherwandung. Das ein- oder mehrstufige Spannungsreglerteil ist mit der Hochspannungskaskade baulich integriert ; hierzu ist das am Kaskadenkörper angebrachte Spannungsreglerteil einerseits mit dem Bleederwiderstand und andererseits mit dem entsprechenden, am hervorkragenden Plattenrand vorgesehenen und daher frei zugänglichen Anschlußstift verbunden. Um den Masseanschluß des Spannungsreglerteils herzustellen, muß die erfindungsgemäße Hochspannungskaskade also lediglich auf die Platine aufgesetzt werden.

Die Erfindung wird im folgenden an einem bevorzugten Ausführungsbeispiel an Hand der Zeichnung erläutert.

Es zeigt :

Fig. 1 ein Schaltbild einer HochspannungsKaskade für die Hochspannungs-Erzeugung in Farbfernsehgeräten ;

Fig. 2 eine geschnittene Vorderansicht einer Hochspannungs-Kaskade mit integriertem Bleeder (Schnittlinie II-II in Fig. 3) ;

Fig. 3 eine geschnittene Seitenansicht der Anordnung in Fig. 2 (Schnittlinie III-III in den Fig. 2 und 4) ;

Fig. 4 eine geschnittene Rückansicht der Anordnung in Fig. 2 (Schnittlinie IV-IV in Fig. 3) ;

Fig. 5 eine vereinfachte Vorderansicht einer erfindungsgemäßen Ausführungsform einer Hochspannungs-Kaskade mit gesondert vergossenem Bleeder ;

Fig. 6 eine teilweise abgebrochene Seitenansicht der Anordnung in Fig. 5 (Blickrichtung VI in Fig. 5) ; und

Fig. 7 eine Draufsicht auf die Anordnung gemäß Fig. 5 und 6.

Die Kaskadenschaltung gemäß Fig. 1 liefert aufgrund einer als Pumpspannung $U_P$ bezeichneten Wechselspannung eine als Hochspannung $U_H$ bezeichneten Gleichspannung, deren Spannungswert etwa dem dreifachen Scheitelspannungswert der Pumpspannung entspricht. Bei einer beispielsweise von einer Zeilenablenkstufe eines Farbfernsehgerätes gelieferten zwischen ± 8 kV variierenden Pumpspannung ergibt sich demnach eine Hochspannung von etwa 24 kV, welche als Bildröhrenhochspannung dient. Die Hochspannungs-Kaskadenschaltung besteht aus zwei Reihen von Kondensatoren C1 bis C5, welche über Dioden D1 bis D5 miteinander verbunden sind. Die aus den beiden Kondensatoren C1 und C2 bestehende Reihe wird als Pumpsäule bezeichnet, die aus den drei Kondensatoren C3 bis C5 bestehende Reihe als Speichersäule. An dem in Fig. 1 linken Ende der Pumpsäule, d. h. am Kondensator C1, welches als Niederspannungsende der Pumpsäule bezeichnet werden kann, liegt die Pumpspannung $U_P$ an. Das in Fig. 1 ebenfalls links angeordnete Niederspannungsende der Speichersäule liegt an Masse, so daß der erste Kondensator C5 dieser Säule auch als Massekondensator bezeichnet werden kann. Die Diode D1 ist zwischen das Niederspannungsende der Pumpsäule und den Verbindungspunkt der Kondensatoren C5 und C4 der Speichersäule mit Durchlaßrichtung zur Speichersäule hin geschaltet ; die Diode D2 ist zwischen den Verbindungspunkt der beiden Kondensatoren C5 und C4 und den Verbindungspunkt der beiden Kondensatoren C1 und C2 mit Durchlaßrichtung zur Pumpsäule hin geschaltet usw. Ferner ist eine Klemmdiode D6 vorgesehen, welche zwischen Masse und das Niederspannungsende der Pumpsäule geschaltet ist mit Durchlaßrichtung zur Pumpsäule hin. Fig. 1 gibt die bei der Ausführungsform der Hochspannungs-Kaskade gemäß Fig. 2 bis 4 verwendete Form der Verdrahtung wieder.

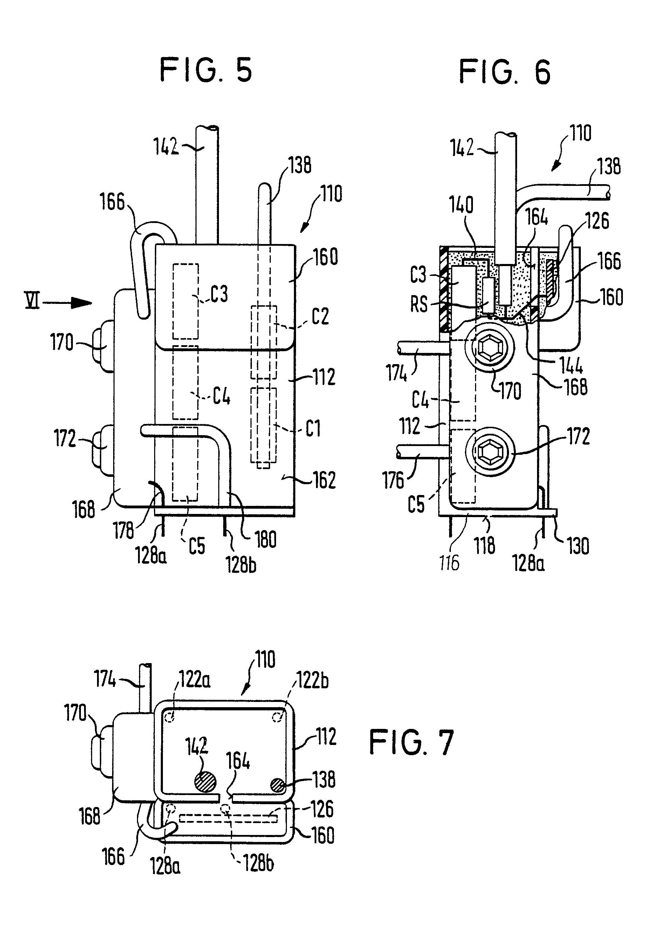

Man erkennt, daß die Dioden in der Reihenfolge D6, D1, D2, D3, D4 und D5 hintereinander geschaltet sind in gleicher Durchlaßrichtung, und daß die Verknüpfungspunkte aufeinander folgender Dioden leiterartig abwechselnd mit den Kondensatoren der Pumpsäule und der Speichersäule verbunden sind. In die Hochspannungsleitung ist ein mit « RS » bezeichneter Schutzwiderstand eingeschaltet. Anschließend an diesen Schutzwiderstand zweigt eine zu Widerständen R1 und R2 führende Leitung ab. Diese Widerstände R1 und R2 werden von einem als Bleeder 26 bezeichneten Entladewiderstand gebildet. In der Ausführungsform gemäß Fig. 2 bis 4 liefert ein Mittelabgriff zwischen den widerständen R1 und R2 eine mit $U_F$ bezeichnete Fokusspannung. In der Ausführungsform gemäß Fig. 5 bis 7 dagegen sind die Widerstände R1 und R2 zu einem einzigen Widerstand vereinigt ; die Fokusspannung $U'_F$ wird von einem Spannungsregler R3 geliefert, welcher sich an den Bleeder 26 anschließt. Die Fokusspannung liegt im Bereich von 8-9 kV. An den Spannungsregler R3 kann sich ein zweiter Spannungsregler R4 anschließen, welcher eine ebenfalls regelbare Spannung, z. B. eine Gitterspannung $U_G$ im Bereich zwischen 4 und 5 kV, liefert.

Die Hochspannungskaskade 10 gemäß Fig. 2 bis 4 besteht aus einem Bechergehäuse 12, welches die vorstehend beschriebenen Kondensatoren C1 bis C5 und Dioden D1 bis D6 sowie den Schutzwiderstand RS aufnimmt und mit einem Epoxydharz 14 in flammwidriger Zusamnensetzung vergossen ist. Das Bechergehäuse 12 aus flammwidrigem Kunststoff besitzt einen Becherboden 16, welcher entweder, wie dargestellt, ein gesondertes Bauteil bildet oder einstückig mit dem übrigen Bechergehäuse ausgebildet ist. Die Außenseite des Becherbodens 16 wird als Platinen-Anschlußfläche 18 bezeichnet, da diese, wie in Fig. 3 angedeutet ist, unmittelbar auf eine Schaltungsplatine 20 aufgesetzt werden kann, wobei noch zu beschreibende, von der Fläche 18 senkrecht abstehende Lötstifte 22 entsprechende Platinenbohrungen 24 durchsetzen und an der Platinenunterseite 27 verlötet sind. Hierdurch ist die Hochspannungs-Kaskade mit seinen an die Lötstifte 22 angeschlossenen Niederspannungsanschlüssen in die gedruckte Schaltungs-Platine 20 integriert. Nach dem Verlöten der Lötstifte 22 können die über die Unterseite 27 der Platine 20 vorstehenden Stiftenden abgeschnitten werden.

Das Niederspannungsende der Speichersäule, also der Kondensator C5, ist mit einem mit 22a bezeichneten Lötstift unmittelbar verbunden. Die Klemmdiode D6 ist an einen Lötstift 22b angeschlossen und das masseseitige Ende des die widerstände R1 und R2 bildenden Bleeders 26 an einen Lötstift 22c. Am Gehäuse 12 der Hochspannungs-Kaskade 10 wird erfindungsgemäß ein Spannungsregler angebracht. Entsprechend der noch zu beschreibenden erfindungsgemäßen Ausführungsform gemäß Fig. 5 und 7, sind eine oder mehrere Zusatzlötstifte 28 vorgesehen, welche einen über den Querschnitt des Gehäuses 12 in Fig. 3 nach links vorkragenden Randstreifen 30 des Becherbodens 16 durchsetzen und daher von oben her zugänglich sind.

Die Kondensatoren der Pump- und Speichersäule bestehen aus länglich zylindrischen, beidendig kontaktierten Wickelkondensatoren. Die Kondensatoren jeder Säule sind gleich orientiert und derart hintereinander angeordnet, daß ihre Längsachsen (Zylinderachsen) zusammenfallen und damit die Längsrichtung 32 der Speichersäule bzw. die Längsrichtung 34 der Pumpsäule definieren. Die beiden Richtungen 32 und 34 verlaufen parallel zueinander und in Höhenrichtung A des oben offenen Bechergehäuses 12. Die beiden Kondensatoren C1 und C2 liegen symmetrisch zum mittleren Kondensator C4, mit anderen Worten, die beiden Kondensatoren C2 und C1 sind gegenüber den Kondensatoren C3 und C4 etwa um die Hälfte der Kondensatorlänge a in Längsrichtung 34 zum Becherboden 18 hin versetzt.

Aufeinanderfolgende Kondensatoren der beiden Säulen sind über angenähert u-förmig gebogene, mit den Stirnkontaktierungen verlötete Anschlußdrähte 36 miteinander verbunden. Jeweils einer der beiden Schenkel eines Anschlußdrahtes 36 steht über dem jeweiligen Kondensatorumriß in Richtung zur gegenüber liegenden Kondensatorreihe vor. Aufgrund der angegebenen gegenseitigen Versetzung der Kondensatoren der beiden Säulen folgt in Höhenrichtung A des Bechergehäuses 12 auf einen Anschlußdraht 36 z. B. der Speichersäule, ein Anschlußdraht 36' der Pumpsäule. In Fig. 2 am oberen Ende des Kondensators C2 (Hochspannungsende der Pumpsäule) sowie am unteren Ende des Kondensators C1 (Niederspannungsende der Pumpsäule) ist ebenfalls ein auf die gegenüber liegende Säule zulaufender Anschlußdraht 36' stirnseitig an den jeweiligen Kondensator angelötet. Am oberen Ende des Kondensators C3 (Hochspannungsende der Speichersäule) ist ebenfalls ein entsprechender Anschlußdraht 36 festgelötet. Zwischen die aufeinanderfolgenden Anschlußdrähte 36' und 36 ist nun ausgehend vom Anschlußdraht 36' am unteren Ende des Kondensators C1 bis zum Anschlußdraht 36 am oberen Ende des Kondensators C3 jeweils eine der Dioden D1 bis D5 zwischengeschaltet. Die Anschlußdrähte der demzufolge ebenfalls in Höhenrichtung A des Bechergehäuses 12 orientierten Dioden sind mit den Anschlußdrähten 36 bzw. 36' verlötet oder verschweißt. Die Verschweißung ist bevorzugt, da diese aufgrund der freiliegenden Schweißstellen problemlos durchführbar ist und eine zuverlässigere Verbindung herstellt. Die bereits erwähnte Klemmdiode D6 ist einerseits mit dem Lötstift 22 b und andererseits mit dem unteren Ende der Diode D1 verbunden.

Die Pumpspannung $U_P$ wird dem unteren Ende des Kondensators C1 über eine Pumpspannungs-Anschlußleitung 38 zugeführt. Die Anschlußleitung 38 verläuft ausgehend am unteren Ende des Kondensators C 1 in Höhenrichtung A des Bechergehäuses 12, um schließlich das offene obere Ende des Bechergehäuses 12 zu verlassen.

Vom oberen Ende des Kondensators C3 (Hochspannungsende der Speichersäule) geht eine Verbindungsleitung 40 zum Schutzwiderstand RS. An das andere Ende des Schutzwiderstands RS ist zum einen eine aus dem oberen Ende des Bechergehäuse 12 herausgeführte Hochspannungs-Anschlußleitung 42 angeschlossen und zum anderen über eine Leitung 44 der bereits erwähnte Bleeder 26. Der Bleeder 26 in Form einer einen Schichtwiderstand tragenden Keramikplatte, welche in einem nicht dargestellten Halterahmen gemäß dem deutschen Gebrauchsmuster DE-U-7 816 370 eingesetzt sein kann, weist einen Widerstandsabgriffspunkt 46 auf, an den eine Fokusspannungsleitung 48 angeschlossen ist. Diese Leitung 48 ist wiederum aus dem offenen Gehäuseende herausgeführt. Der Schichtwiderstandsbereich oberhalb des Abgriffspunktes 46 bildet den Widerstand R1 und der Bereich unterhalb des Abgriffspunktes den widerstand R2 gemäß Fig. 1.

Das untere (masseseitige) Ende des Bleeders 26 ist, wie bereits erwähnt, mit dem Lötstift 22c leitend verbunden. Die vorstehend beschriebene Hochspannungskaskade ist einfach in der Herstellung, da die leiterartige Anordnung (mit versetzten Sprossen) der Kondensatoren C 1 bis C 5 samt den Dioden D 1 bis D 6 problemlos zusammenstellbar ist. Das Anfügen des Bleeders 26, des Schutzwiderstandes RS sowie der Leitungen 38, 42 und 48 bereitet auch keine Schwierigkeiten. Die so erhaltene Anordnung wird in das Bechergehäuse eingeführt und die Verbindung mit den Lötstiften hergestellt. Falls der Becherboden ein gesondertes Bauteil bildet, wird zuerst die Verbindung mit den Lötstiften hergestellten und anschließend der Bechergehäusemantel auf- geschoben.

Wie bereits erwähnt, kann die Hochspannungs-Kaskade unmittelbar auf eine Schaltungsplatine 20 aufgesetzt und mit dieser über die Lötstifte 22 verlötet werden. Der Platinen-Flächenbedarf ist gering ; so beträgt die Breite b des Bechergehäuses 10 etwa 3 cm und die Tiefe c etwa 2,5 cm. Die Höhe d liegt dagegen bei etwa 8 cm, was jedoch keine Einschränkung darstellt, da in dieser Richtung zumeist ausreichend Platz ist. Auch sorgt diese relativ große Höhe dafür, daß die hochspannungsführenden Leitungen ausreichenden Abstand von der Schaltungsplatine 20 einhalten. Aufgrund der beschriebenen versetzten Anordnung der beiden Kondensatorreihen (Verschiebung des unteren Endes des Kondensators C 1 gegenüber dem Kondensator C 5 um etwa eine halbe Kondensatorlänge a in Richtung weg vom Gehäuseboden 16 ergibt sich ein ausreichend hoher Abstand der hochspannungsführenden Bauteile Innerhalb des Bechergehäuses 12 von der Schaltungsplatine, 20, so daß die Gefahr der Induzierung von Fehlerspannungen bzw. Fehlerströmen praktisch beseitigt ist.

Die in den Fig. 5 bis 7 gezeigte erfindungsgemäße Ausführungsform einer mit einem Spannungsreglerteil integrierte Hochspannungs-Kaskade ist mit 110 bezeichnet, wobei Bauelemente dieser Ausführungsform, die solchen der Hochspannungs-Kaskade 10 gemäß Fig. 1 bis 4 entsprechen, mit denselben Bezugsziffern versehen sind, jeweils vermehrt um die Zahl 100.

Die Hochspannungskaskade 110 besteht ebenfalls aus einem nach oben hin offenen Bechergehäuse 112, welches die Bauelemente der Kaskadenschaltung aufnimmt. Der Bleeder 126 ist jedoch abweichend von der vorher beschriebenen Ausführungsform nicht zusammen mit den Kondensatoren C 1 bis C 5 in das Bechergehäuse 112 eingegossen, sondern aus Gründen besserer Wärmeabkopplung in ein Zusatzgehäuse teil 160 eingegossen, welches sowohl nach oben hin als auch zu der in Fig. 5 erkennbaren Vorderseite 162 des Gehäuses 112 hin offen ist.

Zum Vergießen wird das Zusatzgehäuseteil 160 an das Bechergehäuse 112 gehalten, so daß sich ein von den Innenflächen des Zusatzgehäuseteils sowie von der Vorderseite 162 des Bechergehäuses begrenzter, nach oben hin offener Ausgießraum bildet. Nach dem Ausgießen verbindet das verwendete Epoxydharz das Zusatzgehäuseteil 160 mit dem Bechergehäuse 112. Der Bleeder 126 ist mit dem in das Bechergehäuse 112 eingegossenen Schutzwiderstand RS über eine Verbindungsleitung 144 verbunden, welche zur Erleichterung des Zusammembaus einen nach oben hin offenen Schlitz 164 des Bechergehäuses 112 durchsetzt. Wie in Figur 6 angedeutet ist der Schutzwiderstand RS auf der Bleeder-Seite mit der Hochspannungs-Anschlußleitung 142 verbunden und auf der anderen Seite über eine Verbindungsleitung 140 mit dem oberen Ende des Kondensators C 3. Die Pumpspannungs-Anschlußleitung 138 geht vom in Fig. 5 angedeuteten Kondensator C 1 aus und ist ebenso wie die Hochspannungs-Anschlußleitung 142 oben aus dem Bechergehäuse 112 herausgeführt.

Vom Bleeder 126 geht eine Verbindungsleitung 166 aus, welche das Zusatzgehäuseteil 160 an seiner offenen Oberseite verläßt und zu einem zweistufigen Spannungsreglerteil 168 führt. Das Teil 168 ist seitlich am Bechergehäuse 122 befestigt, vorzugsweise angeklebt. Es besteht aus zwei einzelnen Spannungsreglern 170 und 172, deren konstruktiver Aufbau aus der DE-C-2 600 156 hervorgeht. Der als erstes auf den Bleeder 126 folgende Spannungsregler 170 entspricht dem regelbaren Widerstand R 3 in Fig. 1 und liefert die Spannung $U_F$; dementsprechend liefert der nächste Spannungsregler 172 als regelbarer Widerstand R 4 die Spannung $U_G$. Die entsprechenden Ausgangsleitungen 174 bzw. 176 sind in den Fig. 6 und 7 angedeutet.

Das masseseitige Ende des Spannungsreglers 172 ist z. B. über zwei Verbindungsleitungen 178 und 180 mit Zusatzlötstiften 128a und 128b verbunden, welche einen hervorkragenden Plattenrand 130 des Becherbodens 116 durchsetzen, der als Anschlußplatte mit einer Platinen-Anschlußfläche 118 zum unmittelbaren Aufsetzen auf eine Schaltungsplatine ausgebildet ist. Die Lage der Zusatzlötstifte ist in Fig. 7 strichliert angedeutet, ebenso wie die Lage der Lötstifte 122a und 122b, welche den Masseanschluß des Massekondensators C 5 bzw. der Klemmdiode D 6 herstellen.

## Patentansprüche

1. Hochspannungskaskade, insbesondere für Fernsehgeräte, umfassend innerhalb eines vergossenen Kaskadenkörpers eine erste und eine zweite jeweils wenigstens einen Teil der Pumpsäule bzw. der Speichersäule einer Kaskadenschaltung bildende Reihe jeweils aus länglichen, im wesentlichen gleich orientierten, in Richtung der jeweiligen Kondensatorlängsachsen hintereinander angeordneten, elektrisch unmittelbar miteinander verbundenen Kondensatoren (C1 bis C5) und ferner umfassend mehrere zwischen die Kondensatoren der beiden parallel nebeneinander angeordneten Reihen geschaltete Dioden (D1 bis D6) der Kaskadenschaltung, sowie einen mit dem Hochspannungsende der Speichersäule verbundenen Bleederwiderstand (126), wobei an das Niederspannungsende der Pumpsäule eine Pumpspannungs-Anschlußleitung (138), an das Hochspannungsende der Speichersäule eine Hochspannungs-Anschlußleitung (142) und an den Bleederwiderstand (126) eine Bleederwiderstands-Anschlußleitung (166) angeschlossen sind, und wobei der Kaskadenkörper mit einem ausgegossenen Bechergehäuse (112) gebildet ist, welches im Bereich der Niederspannungsenden der beiden Säulen mit einer zu den Reihenlängsrichtungen im wesentlichen senkrechten Anschlußplatte ausgebildet ist, die über den Querschnitt des Kaskadenkörpers wenigstens an einer Seite hervorkragt und wobei ferner unter Spannungen im kV-Bereich liegende Anschlußleitungen (138, 142) aus dem Kaskadenkörper im Bereich von dessen der Anschlußplatte gegenüberliegendem Ende herausgeführt sind, dadurch gekennzeichnet, daß die Pumpspannungs-, die Hochspannungs- und die Bleederwiderstands-Anschlußleitung (138, 142, 166) aus der Becheröffnung herausgeführt sind, daß der hervorkragende Plattenrand (130) der mit einer Platinen-Anschlußfläche (118) ausgebildeten Anschlußplatte mit wenigstens einem Anschlußstift (128) zur Kontaktierung mit einer Platine versehen ist, und daß am Kaskadenkörper ein ein- oder mehrstufiges Spannungsreglerteil (168) angebracht ist, das masseseitig mit wenigstens einem der Anschlußstifte (128a, 128b) verbunden ist und das über die Bleederwiderstands-Anschlußleitung (166) an den Bleederwiderstand (126) angeschlossen ist.

2. Hochspannungskaskade nach Anspruch 1, dadurch gekennzeichnet, daß ein in die Hochspannungs-Anschlußleitung (142) eingesetzter Schutzwiderstand (RS) im Kaskadenkörper vergossen ist.

## Claims

1. High-tension cascade particularly for television receivers, comprising inside a cast cascade body and forming in each case a part of the pump column or memory column of a cascade circuit, a first and a second row of in each case elongated, substantially identically orientated capacitors (C1 to C5) which are directly connected to one another electrically and disposed seriatim in the direction of the relevant longitudinal axes of the capacitors, and further comprising, disposed between the capacitors of the two parallel rows, a plurality of diodes (D1 to D6) of the cascade circuit, and with, connected to the high-tension end of the memory column, a bleeder resistor (126), a pump voltage connecting lead (138) being connected to the low-voltage end of the pump column, a high voltage connecting lead (142) being connected to the high-tension end of the memory column and a bleeder resistor connecting lead (146) being connected to the bleeder resistor (126), the cascade body being formed with a compound-filled beaker housing (112), which in the region of the low-voltage ends of the two columns is constructed with a connection plate which is substantially at right-angles to the longitudinal directions of the rows and projects beyond the cross-section of the cascade body at least on one side and connecting leads (138, 142) carrying voltages in the kilovolt range are lead out of the cascade body in the region of its end which is opposite that of the connection plate, characterised in that the pump voltage, the high voltage and the bleeder resistor connecting leads (138, 142, 166) are lead out of the beaker orifice, and in that the protruding plate edge (130) of the connection plate which is constructed with a plate connection face (118) is provided with at least one contact pin (128) for making contact with a plate, and in that mounted on the cascade body there is a single- or multi-stage voltage regulator part (168) which on the earth side is connected to at least one of the contact pins (128a, 128b) and to the bleeder resistor (126) via the bleeder resistor connecting lead (166).

2. High-tension cascade according to Claim 1, characterised in that a protective resistor (RS) inserted into the high voltage connecting lead (142) is cast within the cascade body.

**Revendications**

1. Cascade haute tension, en particulier pour appareils de télévision, comprenant, à l'intérieur d'un corps de cascade coulé, des première et seconde rangées formant respectivement au moins une partie de la colonne de pompage ou de la colonne d'accumulation d'un circuit cascade, et respectivement constituées par des condensateurs allongés (C1 à C5) orientés sensiblement de la même façon, disposés à la suite les uns des autres selon la direction des axes longitudinaux respectifs des condensateurs et en liaison électrique directe les uns avec les autres, et comprenant en outre plusieurs diodes (D1 à D6) du circuit cascade montées entre les condensateurs des deux rangées disposées parallèlement l'une à côté de l'autre, ainsi qu'une résistance de fuite (126) reliée à l'extrémité haute tension de la colonne d'accumulation, un conducteur (138) de raccordement de la tension de pompage, un conducteur (142) de raccordement de la haute tension et un conducteur (166) de raccordement de la résistance de fuite étant respectivement reliés à l'extrémité basse tension de la colonne de pompage, à l'extrémité haute tension de la colonne d'accumulation et à la résistance de fuite (126), le corps de cascade étant muni d'un boîtier coulé (112) en cuvette réalisé doté, au voisinage des extrémités basse tension des deux colonnes, d'une plaque de raccordement qui est sensiblement perpendiculaire aux directions longitudinales des rangées et qui fait saillie, au moins d'un côté, au-delà de la section transversale du corps de cascade, des conducteurs de raccordement (138, 142), auxquels sont appliquées des tensions de l'ordre du kV, sortant par ailleurs du corps de cascade dans la région de l'extrémité de celui-ci qui est opposée à la plaque de raccordement, caractérisée par le fait que les conducteurs respectifs (138, 142, 166) de raccordement de la tension de pompage, de la haute tension et de la résistance de fuite sortent par l'ouverture de la cuvette ; par le fait que le bord (130) en saillie de la plaque de raccordement, réalisée pourvue d'une surface (118) de raccordement à une platine, est muni d'au moins une cosse de raccordement (128) pour établir le contact avec une platine ; et par le fait qu'un élément (168) régulateur de tension à un ou plusieurs étages, installé sur le corps de cascade, est relié côté masse à au moins l'une des cosses de raccordement (128a, 128b) et est raccordé à la résistance de fuite (126) par l'intermédiaire du conducteur (166) de raccordement de la résistance de fuite.

2. Cascade haute tension selon la revendication 1, caractérisée par le fait qu'une résistance de protection (RS), incorporée dans le conducteur (142) de raccordement de la haute tension, est coulée dans le corps de cascade.

# FIG. 1

# FIG. 2

# FIG. 3

# FIG. 4

# FIG. 5

# FIG. 6

# FIG. 7